Europäisches Patentamt

European Patent Office

Office européen des brevets

(19)

(11) Veröffentlichungsnummer : **0 131 238**
**B1**

(12) **EUROPÄISCHE PATENTSCHRIFT**

(45) Veröffentlichungstag der Patentschrift :
09.11.88

(51) Int. Cl.⁴ : **G 03 F  7/08**

(21) Anmeldenummer : 84107698.7

(22) Anmeldetag : 03.07.84

(54) **Verfahren zur Herstellung negativer Kopien mittels eines Materials auf Basis von 1,2-Chinondiaziden.**

(30) Priorität : 11.07.83 DE 3325023

(43) Veröffentlichungstag der Anmeldung :
16.01.85 Patentblatt 85/03

(45) Bekanntmachung des Hinweises auf die Patenterteilung : 09.11.88 Patentblatt 88/45

(84) Benannte Vertragsstaaten :
AT BE CH DE FR GB IT LI NL SE

(56) Entgegenhaltungen :
EP-A- 0 021 719
DE-A- 2 461 912
WILEY SERIES ON PHOTOGRAPHIC SCIENCE AND
TECHNOLOGY AND THE GRAPHIC ARTS, J. KOSAR:
"Light-sensitive systems", 1965, Seiten 339-351,
John Wiley & Sons, Inc., London, GB;
Die Akte enthält technische Angaben, die nach dem
Eingang der Anmeldung eingereicht wurden und die
nicht in dieser Patentschrift enthalten sind.

(73) Patentinhaber : HOECHST AKTIENGESELLSCHAFT
Postfach 80 03 20
D-6230 Frankfurt am Main 80 (DE)

(72) Erfinder : Stahlhofen, Paul, Dr.
Leibnizstrasse 18b
D-6200 Wiesbaden (DE)
Erfinder : Mack, Gerhard, Dr.
Mainstrasse 32
D-6200 Wiesbaden (DE)

EP 0 131 238 B1

## Beschreibung

Die Erfindung betrifft ein Verfahren zur Herstellung von negativen Reliefkopien, bei dem ein lichtempfindliches Material, das ein wasserunlösliches, in wäßrig-alkalischen Lösungen lösliches Bindemittel und als lichtempfindliche Verbindung ein 1,2-Chinondiazid enthält, bildmäßig belichtet, danach erwärmt, nach dem Abkühlen nochmals ohne Vorlage belichtet und dann mittels eines wäßrig-alkalischen Entwicklers entwickelt wird.

Es ist bekannt, auf Basis von 1,2-Naphthochinondiaziden beruhende positiv arbeitende Reproduktionsmaterialien durch eine bestimmte Folge von Behandlungsschritten negativ zu verarbeiten. In der US-A 3 264 104 ist ein derartiges Umkehrverfahren beschrieben, bei dem die lichtempfindliche Schicht, die bevorzugt thermoplastische Polymere enthält, bildmäßig belichtet, mit einer alkalischen Lösung oder mit Wasser, gegebenenfalls bei erhöhter Temperatur, behandelt wird, ohne die belichteten Stellen auszuwaschen, nochmals ohne Vorlage belichtet und dann wie üblich entwickelt wird, wobei die ursprünglich bildmäßig belichteten Stellen stehenbleiben und die übrigen Stellen ausgewaschen werden.

Dieses Verfahren hat den Nachteil, daß es eine verhältnismäßig große Zahl von Behandlungsschritten erfordert, daß die erste Alkalibehandlung stets mit besonderer Sorgfalt erfolgen muß, um möglichst wenig von der in wäßrigem Alkali löslichen belichteten Schicht abzulösen, und daß es den Zusatz von in Alkali schwerlöslichen Polymeren erfordert, die die Verwendbarkeit des Materials für andere Zwecke einschränken.

Aus der EP-A 24916 ist für die Herstellung von Resistschichten ein ähnliches Umkehrverfahren bekannt, bei dem ein Material auf Basis von 1,2-Chinondiaziden nach bildmäßiger Belichtung erhitzt, dann ohne Vorlage nachbelichtet und mit wäßrigem Alkali zum Negativ entwickelt wird. Das Material enthält in der lichtempfindlichen Schicht bestimmte photochrome Verbindungen, die beim Erwärmen mit den Lichtreaktionsprodukten des Chinondiazids reagieren und zu einer Schichthärtung führen sollen. Dieses Material ist an die Anwesenheit von photochromen Substanzen gebunden, deren Lichtreaktion eine bei manchen Anwendungen störende Verfärbung ergibt.

In der GB-A 2 082 339 wird ein lichtempfindliches Gemisch, bestehend aus einem o-Chinondiazid und mindestens einem Resol, für die Herstellung einer lithografischen Druckplatte beschrieben, die ebenfalls sowohl positiv als auch negativ verarbeitet werden kann. Dieses Umkehrverfahren enthält die gleiche Folge von Schritten wie das zuvor genannte. Seine Wirkung beruht darauf, daß die Lichtzersetzungsprodukte des o-Chinondiazids mit dem Resol in der Wärme ein unlösliches Reaktionsprodukt ergeben. Diese Reaktion tritt mit Novolaken nicht ein. Von Nachteil ist die relativ mangelhafte Lagerfähigkeit dieser Druckplatten infolge der Eigenhärtung von Resolen.

In den DE-A 2 855 723 und 2 529 054 werden Resistschichten auf Basis von 1,2-Chinondiaziden für ein Umkehrverfahren beschrieben, die als Zusatz zur thermischen Schichthärtung N-Acyl-N'-methylol-ethylendiamine oder Hydroxyethylimidazole enthalten. Ein ähnliches Material mit einem Gehalt an sekundären oder tertiären Aminen wird in der US-A 4 196 003 beschrieben.

Derartige Zusätze haben jedoch im allgemeinen einen nachteiligen Einfluß auf die Lagerfähigkeit der Kopierschichten und auf bestimmte kopiertechnische Eigenschaften, z. B. die Lichtempfindlichkeit und den Bildkontrast nach dem Belichten.

Aus DE-A 24 61 912 ist ein Verfahren zur Ausbildung eines Bildes bekannt, bei welchem bildweise ein lichtempfindliches Vervielfältigungselement mit einer Beschichtung aus einem o-Chinondiazid und einer hydroxylgruppenhaltigen Verbindung, belichtet, die Beschichtung gleichzeitig mit der bildweisen Belichtung oder nach der bildweisen Belichtung erhitzt wird, und mindestens die unbelichteten Bereiche der Beschichtung mit aktiven Strahlen bestrahlt werden und die Beschichtung unter Entfernen der unbelichteten Bereiche entwickelt wird. Man verwendet hierzu o-Chinondiazidverbindungen, die in 5-Stellung substituierte Sulfonsäureester darstellen, und Novolake oder Bisphenol A, Pyrogallol oder Triethanolamin. Die Durchführung des Verfahrens wird auf die Anwesenheit von Hydroxygruppen in der lichtempfindlichen Beschichtung zurückgeführt, eine technische Realisierung konnte aber nicht erreicht werden.

Aus Wiley Series on Photographic Science and Technology and the Graphic Arts, J. Kosar, Light-sensitive Systems, 1965, Seiten 339-351 sind unter o-Chinondiaziden o-Naphthochinondiazide aufgeführt, die sowohl in 4- als auch in 5-Stellung durch Sulfonsäureester substituiert sind. Eine Bevorzugung bestimmter Derivate geht hieraus nicht hervor.

Aufgabe der Erfindung war es, ein Umkehrverfahren zur Herstellung negativer Kopien mittels eines normalerweise positiv arbeitenden lichtempfindlichen Materials auf Basis von 1,2-Chinondiaziden vorzuschlagen, das die angegebenen Nachteile nicht aufweist und bei dem keine Zusätze zur Kopierschicht erforderlich sind, um eine thermische Härtung der belichteten Schichtbereiche zu ermöglichen.

Gegenstand der Erfindung ist ein Verfahren zur Herstellung von negativen Reliefkopien, bei dem ein lichtempfindliches Material, das ein wasserunlösliches, in wäßrig-alkalischen Lösungen lösliches Bindemittel und als lichtempfindliche Verbindung ein 1,2-Chinondiazid enthält, bildmäßig belichtet, danach erwärmt, nach dem Abkühlen nochmals ohne Vorlage belichtet und dann mittels eines wäßrig-alkalischen Entwicklers entwickelt wird.

Das erfindungsgemäße Verfahren ist dadurch gekennzeichnet, daß das Material als lichtempfindliche Verbindung ein Veresterungsprodukt aus 4-(2-Phenyl-prop-2-yl) phenol und 1,2-Benzochinon-2-diazid-4-sulfonsäure bzw. 1,2-Naphthochinon-2-diazid-4sulfonsäure oder einen Ester oder ein Amid einer 1,2-Benzochinon-2-diazid-4-carbonsäure oder einer 1,2-Naphthochinon-2-diazid-4-carbonsäure enthält.

Es war überraschend, daß die Chinon-(1, 2)-diazid-(2)-4-derivate als Sensibilisatoren für das beschriebene Umkehrverfahren wesentlich besser geeignet sind als die entsprechenden Naphthochinon-(1, 2)-diazid-(2)-5-derivate.

Wie erfindungsgemäß gefunden wurde, werden z. B. im Gegensatz zu den o-Chinondiazid-5-sulfonsäureestern bei Verwendung der o-Chinondiazid-4-sulfonsäureester als Sensibilisatoren in der Kopierschicht die bestrahlten Schichtbereiche bei erhöhter Temperatur auch ohne Zusätze ausgehärtet und damit unlöslich im Entwickler. Diese thermische Härtung ist mit o-Chinondiazid-5-derivaten nur möglich, wenn den Kopierschichten besondere Zusätze beigefügt werden, die die Verfestigung der bestrahlten Schichtbereiche bewirken.

Während z. B. eine Kopierschicht, die einen erfindungsgemäßen Naphthochinon (1,2)-diazid-(2)-4-sulfonsäureester und als Bindemittel einen Kresol-Formaldehyd-Novolak enthält, nach dem Bestrahlen mit UV-Strahlung beim Erwärmen auf 140 °C bereits nach einer Minute ausgehärtet und im Entwickler unlöslich geworden ist, härtet bei Verwendung des entsprechenden Naphthochinon-(1, 2)-diazid-(2)-5-sulfonsäureesters unter sonst gleichen Versuchsbedingungen die bestrahlte Kopierschicht bei 140 °C nicht aus und bleibt infolgedessen auch im Entwickler löslich. Erst nach 3 Minuten Erwärmen der bestrahlten Kopierschicht ist eine leichte Härtung der Schicht festzustellen, die jedoch noch keine Resistenz gegenüber dem Entwickler bewirkt. Wird die Verweilzeit bei 140 °C erhöht, z. B. auf 4 oder 5 Minuten, so beginnen bereits die nicht belichteten Schichtbestandteile sich zu zersetzen und werden im Entwickler schwer- bzw. unlöslich, so daß eine Differenzierung zwischen einer negativen und positiven Kopie nicht möglich wird.

Erst durch bestimmte Zusätze zur Schicht, z. B. eines Resols, eines sekundären bzw. tertiären Amins oder von anderen Verbindungen, wird auch mit einem Naphthochinon(1, 2)-diazid-(2)-5-sulfonsäureester eine Umkehrentwicklung möglich.

Der Vorteil des erfindungsgemäß beanspruchten Verfahrens liegt darin, daß bei Verwendung der erfindungsgemäßen o-Chinondiazid-4sulfonsäure- oder -carbonsäurederivate als Sensibilisatoren für die Kopierschicht Zusätze der beschriebenen Art nicht erforderlich sind und daher bestimmte durch diese Zusätze verursachte kopiertechnische Nachteile nicht auftreten können.

Brauchbare Sensibilisatoren, die gemäß der Erfindung verwendet werden können, sind das Veresterungsprodukt aus 4-(2-Phenyl-prop-2-yl) phenol und 1,2-Benzochinon- bzw. 1,2-Naphtho-

chinon-2-diazid-4-sulfonsäure oder 1,2-Chinondiazid-4-carbonsäureester und -amide, die nach dem Bestrahlen mit aktinischem Licht in wäßrig-alkalischen Lösungen löslich werden.

Als Ester kommen die bekannten Umsetzungsprodukte der Carbonsäuren oder ihrer Halogenide mit Phenolen, insbesondere mehrwertigen Phenolen in Betracht, z. B. mit 2,3,4-Trihydroxy-benzophenon, 2,4-Dihydroxy-benzophenon, 4-Decanoyl-resorcin, 4-(2-Phenyl-prop-2-yl) phenol, Gallussäureoctylester, oder 4,4-Bis-(4-hydroxyphenyl)valeriansäurebutylester. Die Amide können in bekannter Weise von aromatischen oder längerkettigen aliphatischen Aminen abgeleitet sein.

Die Menge an o-Chinondiazidverbindungen beträgt im allgemeinen 3 bis 50, bevorzugt 7 bis 35 Gewichtsprozent, bezogen auf die nichtflüchtigen Anteile der Kopierschicht.

Außer den oben angegebenen 4-substituierten o-Chinondiaziden können in dieser Gesamtmenge auch kleinere Anteile an üblichen 1,2-Naphthochinondiazid-5-sulfonsäurederivaten, vorzugsweise -estern, enthalten sein. Die Menge der 5-Sulfonsäurederivate sollte im allgemeinen 50, vorzugsweise etwa 20 Gewichtsprozent der Menge an 4-substituierten Chinondiaziden nicht überschreiten.

Die lichtempfindlichen Gemische enthalten ferner ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Bindemittel auch bei dem erfindungsgemäßen Verfahren als vorteilhaft erwiesen. Die Novolake können auch in bekannter Weise durch Umsetzung eines Teils ihrer Hydroxygruppen, z. B. mit Chloressigsäure, Isocyanaten, Epoxiden oder Carbonsäureanhydriden, modifiziert sein. Als weitere alkalilösliche bzw. in Alkali quellbare Bindemittel werden Polyhydroxyphenylharze, die durch Kondensation aus Phenolen und Aldehyden oder Ketonen hergestellt werden, Mischpolymerisate aus Styrol und Maleinsäureanhydrid, Polyvinylphenole, oder Mischpolymerisate der Acrylsäure oder Methacrylsäure, insbesondere mit Acryl- oder Methacrylsäureestern, bevorzugt.

Die Art und Menge des alkalilöslichen Harzes kann je nach Anwendungszweck verschieden sein ; bevorzugt werden Anteile am Gesamtfeststoff zwischen 90 und 30, besonders bevorzugt 85-55 Gewichtsprozent. Zusätzlich können noch zahlreiche andere Harze mitverwendet werden, bevorzugt Epoxyharze und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren sowie hydrierte oder teilhydrierte Kolophoniumderivate. Der günstigste Anteil an diesen Harzen richtet sich nach den anwendungstechnischen Erfordernissen und dem Einfluß auf die Entwicklungsbedingungen und beträgt im allgemeinen nicht mehr als 50 Gewichtsprozent, bevorzugt etwa 2 bis 35 Gewichtsprozent, vom alkalilöslichen Harz. In geringen Mengen kann das lichtempfindliche Gemisch für spezielle Erfordernisse wie Flexibilität, Haftung, Glanz und Färbung, außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Ferner können dem lichtempfindlichen Gemisch für den Farbumschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphthochinondiazid-4-sulfonsäurechlorid, chromophor substituierte Halogenmethyl-s-triazine oder Diazoniumverbindungen in Form ihrer Salze mit komplexen Säuren wie Borfluorwasserstoffsäure oder Hexafluorphosphorsäure.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether, werden besonders bevorzugt.

Als Schichtträger für Schichtdicken unter ca. 10 μm werden meist Metalle verwendet. Für Offsetdruckplatten können eingesetzt werden : walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag. Belichtet wird mit den in der Technik üblichen Lichtquellen. Auch das Bestrahlen mit Elektronen oder Lasern stellt eine Möglichkeit zur Bebilderung dar.

Zum Entwickeln werden wäßrig-alkalische Lösungen abgestufter Alkalität verwendet, vorzugsweise mit einem pH im Bereich von 10-14, die auch kleinere Mengen organischer Lösungs- oder Netzmittel enthalten können.

Nach dem bildmäßigen Bestrahlen bzw. Belichten wird das Material ohne weitere Zwischenbehandlung erwärmt. Das Erwärmen kann durch Bestrahlung, Konvektion, durch Kontakt mit erwärmten Flächen, z. B. Walzen, oder durch Tauchen in ein erwärmtes Bad einer inerten Flüssigkeit, z. B. Wasser, erfolgen. Die Temperatur kann zwischen 80 und 160, vorzugsweise bei 110 bis 150 °C liegen. Derartige Temperaturen werden von den Gemischen vertragen, ohne daß die Eigenschaften der unbelichteten Bereiche wesentlich verändert werden. Die Dauer des Erwärmens kann je nach Art der Wärmeeinwirkung sehr unterschiedlich sein. Bei Übertragung durch ein Wärmemedium liegt sie im allgemeinen zwischen 1/2 und 30 Minuten, vorzugsweise zwischen 1 und 5 Minuten.

Nach dem Erwärmen und Abkühlen wird die lichtempfindliche Schicht einer Totalbelichtung unterworfen, um die noch lichtempfindlichen Schichtbereiche vollständig in ihre Lichtzersetzungsprodukte umzuwandeln. Die Nachbelichtung kann vorteilhaft unter der gleichen Lichtquelle erfolgen, die zur Bildbelichtung verwendet wurde.

An die Nachbelichtung schließt sich eine Entwicklung mit üblichen Entwicklern an, wobei die Schichtbereiche ausgewaschen werden, die bei der ursprünglichen Bildbelichtung nicht vom Licht getroffen waren. Als Entwickler sind vorzugsweise wäßrige Lösungen von alkalischen Substanzen, z. B von Alkaliphosphaten, -silikaten, -carbonaten oder -hydroxiden geeignet, die ferner Netzmittel oder kleinere Mengen organischer Lösungsmittel enthalten können. In bestimmten Fällen sind auch organische Lösungsmittel oder Gemische derselben mit Wasser als Entwickler geeignet. Die Entwicklung kann unmittelbar nach dem Erwärmen und Abkühlen oder auch in zeitlichem Abstand von z. B. mehreren Stunden erfolgen, ohne daß die gehärteten Schichtbereiche angegriffen werden. Daraus ist zu schließen, daß die Schichthärtung der belichteten Stellen durch Erwärmen irreversibel ist.

Das erfindungsgemäße Verfahren hat den Vorteil, daß keine besonderen Zusätze benötigt werden, die die Verfestigung der belichteten Schichtbereiche bei erhöhter Temperatur erst ermöglichen und daß es weder zusätzliche Behandlungsschritte mit Flüssigkeiten noch eine besondere Zusammensetzung des lichtempfindlichen Materials erfordert. Der einzige zusätzliche Behandlungsschritt, das Erwärmen, kann zumeist mit vorhandenen Trocknungsgeräten bequem durchgeführt werden. Die Nachbelichtung ohne Vorlage wird am einfachsten wieder mit der Kopierlichtquelle durchgeführt.

Das Verfahren ermöglicht es, durch Variation der Belichtungszeiten die Auflösung zu steuern.

Das erfindungsgemäße Verfahren kann z. B. zur Herstellung von Druckformen für den Hoch-, Tief- und Flachdruck sowie von Photoresistschablonen für die subtraktive und additive Leiterplattenherstellung, für die galvanische Herstellung von Nickelrotationszylindern oder für die Maskenherstellung in der Mikroelektronik nach der Liftoff-Technik eingesetzt werden.

Die folgenden Beispiele beschreiben bevorzugte Ausführungsformen des erfindungsgemäßen Verfahrens. Prozentzahlen und Mengenverhältnisse sind, wenn nichts anderes angegeben ist, in Gewichtseinheiten zu verstehen.

Beispiel 1

Mit einer Lösung von

3,00 Gt des Veresterungsproduktes aus 1 mol 4-(2-Phenyl-prop-2-yl) phenol und 1 mol Naphthochinon-(1, 2)-diazid-(2)-4-sulfonsäurechlorid,
0,10 Gt Naphthochinon-(1, 2)-diazid-(2)-4-sulfonsäurechlorid,
6,00 Gt eines Kresol-Formaldehyd-Novolaks mit einem Erweichungspunkt von 105-120 °C nach Kapillar-Methode DIN 53 181,
0,07 Gt Kristallviolett in
50,00 Gt Ethylenglykolmonomethylether und
50,00 Gt Tetrahydrofuran

wurde eine elektrolytisch aufgerauhte und anodisierte Aluminiumplatte beschichtet. Der anodisierte Aluminiumträger war vor dem Aufbringen der lichtempfindlichen Kopierschicht mit einer wäßrigen Lösung von Polyvinylphosphonsäure behandelt worden, wie es in der DE-C 1 621 478 beschrieben ist.

Das so hergestellte vorsensibilisierte Material mit einem Schichtgewicht von ca. 2,0 g/m² wurde unter einer transparenten Positiv-Vorlage bildmäßig belichtet und anschliessend mit einer 2 %igen wäßrigen Lösung von Natriummetasilikat x 9 Wasser entwickelt. Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt. Durch Einfärben mit Fettfarbe wurde eine druckfertige Positiv-Druckform erhalten.

Eine andere Probe des gleichen vorsensibilisierten Materials wurde als Negativ-Druckplatte verarbeitet, indem es unter einer negativen Vorlage belichtet, anschließend 1 Minute auf 140 °C erwärmt und dann ohne Vorlage dieselbe Zeit wie bei der bildmäßigen Belichtung nachbelichtet wurde. Beim Entwickeln im gleichen Entwickler innerhalb der gleichen Zeit entstand das Umkehrbild der Vorlage.

Wird der im Beispiel 1 angegebene Sensibilisator durch den entsprechenden Ester der Naphthochinon-(1, 2)-diazid(2)-5-sulfonsäure ersetzt und unter gleichen Versuchsbedingungen das beschriebene Umkehrverfahren wiederholt, so ist in Gegenwart des Naphthochinondiazid-5-sulfonsäureesters eine Umkehrentwicklung des positiv arbeitenden lichtempfindlichen Materials nicht möglich. Während in Gegenwart des oben angegebenen Naphthochinon-(1, 2)-diazid-(2)-4-sulfonsäureesters bereits nach 1 Minute die belichteten Schichtbereiche bei 140 °C im Entwickler unlöslich geworden sind, sind die belichteten Schichtbereiche mit dem Naphthochinon-(1, 2)-diazid(2)-5-sulfonsäureester auch nach drei Minuten bei 140 °C im Entwickler noch löslich, so daß eine Differenzierung zwischen Positiv- und Negativ-Kopie nicht möglich ist. Wird die Verweilzeit bzw. die Temperatur weiter erhöht, so beginnen sich die nicht belichteten Schichtbereiche zu zersetzen, so daß auch in diesem Falle eine Differenzierung nicht möglich ist.

Beispiel 2

Mit einer Lösung von

4,00 Gt des Naphthochinondiazidsulfonsäureesters von Beispiel 1,
5,00 Gt eines Poly-p-vinylphenols mit einem mittleren Molekulargewicht von 10 000,
0,10 Gt Naphthochinon-(1, 2)-diazid-(2)-4-sulfonsäurechlorid,
0,07 Gt Kristallviolett in
50,00 Gt Ethylenglykolmonomethylether und
50,00 Gt Tetrahydrofuran

wurde eine elektrochemisch aufgerauhte und anodisierte Aluminiumplatte beschichtet, die mit einer wäßrigen Lösung von 0,1 Gewichtsprozent Polyvinylphosphonsäure behandelt worden war.

Das so hergestellte vorsensibilisierte Material wurde unter einer transparente Positiv-Vorlage bildmäßig belichtet und anschließend mit einer 0,5 %igen Natriummetasilikat-Lösung entwickelt, wodurch eine der Vorlage entsprechende positive Druckschablone erhalten wurde.

Eine andere Probe des gleichen Materials wurde als Negativ-Druckplatte verarbeitet, indem unter einer negativen Vorlage belichtet, anschließend 1 Minute auf 140 °C erwärmt und ohne Vorlage dieselbe Zeit wie bei der bildmäßigen Belichtung nachbelichtet wurde. Beim Entwickeln im gleichen Entwickler innerhalb der gleichen Zeit entstand das Umkehrbild der Vorlage.

Beispiel 3

Mit einer Lösung von

3,00 Gt des Naphthochinondiazidsulfonsäureesters von Beispiel 1,
6,00 Gt des Kondensationsproduktes aus 2-Methylresorcin und Aceton mit einem mittleren Molgewicht von 2000,
0,20 Gt Naphthochinon-(1, 2)-diazid-(2)-4-sulfonsäurechlorid,
0,08 Gt Kristallviolett in
50,00 Gt Ethylenglykolmonomethylether und
50,00 Gt Tetrahydrofuran

wurde eine elektrochemisch aufgerauhte und anodisierte Aluminiumplatte beschichtet. Das so hergestellte vorsensibilisierte Material wurde unter einer transparenten Positiv-Vorlage bildmäßig belichtet und anschließend mit einer 6 %igen Natriummetasilikat-Lösung entwickelt, wodurch eine der Vorlage entsprechende positive Druckschablone erhalten wurde.

Eine andere Probe des gleichen Materials wurde als Negativ-Druckplatte verarbeitet, indem sie unter einer negativen Vorlage belichtet, anschließend 3 Minuten auf 140 °C erwärmt und ohne eine Vorlage dieselbe Zeit wie bei der bildmäßigen Belichtung nachbelichtet wurde. Beim Entwickeln im gleichen Entwickler innerhalb der gleichen Zeit entstand das Umkehrbild der Vorlage.

**Patentansprüche**

1. Verfahren zur Herstellung von negativen Reliefkopien, bei dem ein lichtempfindliches Material, das ein wasserunlösliches, in wäßrig-alkalischen Lösungen lösliches Bindemittel und als lichtempfindliche Verbindung ein 1,2-Chinondiazid enthält, bildmäßig belichtet, danach erwärmt, nach dem Abkühlen nochmals ohne Vorlage belichtet und dann mittels eines wäßrig-alkalischen Entwicklers entwickelt wird, dadurch gekennzeichnet, daß das Material als lichtempfindliche Verbindung ein Veresterungsprodukt aus 4-(2-Phenyl-prop-2-yl) phenol und 1,2-Benzochinon-2-diazid-4-sulfonsäure bzw. 1,2-Naphthochinon-2-diazid-4-sulfonsäure oder einen Ester oder ein Amid einer 1,2-Benzochinon-2-diazid-4-carbonsäure oder einer 1,2-Naphthochinon-2-diazid-4-carbonsäure enthält.

2. Verfahren nach Anspruch 1, dadurch gekennzeichnet, daß man das bildmäßig belichtete Material auf eine Temperatur im Bereich von 80-160 °C erwärmt.

3. Verfahren nach Anspruch 1 oder 2, dadurch gekennzeichnet, daß man das Material 30 Sekunden bis 30 Minuten erwärmt.

4. Verfahren nach Anspruch 1, dadurch gekennzeichnet, daß das Bindemittel ein Novolak ist.

5. Verfahren nach Anspruch 1, dadurch gekennzeichnet, daß die lichtempfindliche Schicht des Materials 3 bis 50 Gewichtsprozent an 1,2-Chinondiazidverbindungen, bezogen auf ihre nichtflüchtigen Bestandteile, enthält.

**Claims**

1. Process for producing negative relief copies, which comprises imagewise exposing a light-sensitive material comprised of a binder which is insoluble in water and soluble in aqueous-alkaline solutions and of a 1,2-quinone diazide as the light-sensitive compound, thereafter heating the material and, after cooling, exposing the material again without an original and then developing it by means of an aqueous-alkaline developer, characterized in that the material contains the lightsensitive compound, an esterification product of 4-(2-phenyl-prop-2-yl-) phenol and 1,2-benzoquinone-2-diazide4-sulfonic acid or 1,2-naphthoquinone-2-diazide-4-sulfonic acid, or an ester or an amide of a 1,2-benzoquinone-2-diazide-4-carboxylic acid or a 1,2-naphtho-quinone-2-diazide-4-carboxylic acid.

2. A process as claimed in claim 1, characterized in that the material which has been exposed imagewise is heated to a temperature in the range from 80 to 160 °C.

3. A process as claimed in claim 1 or claim 2, characterized in that the material is heated for a period of time ranging from 30 seconds to 30 minutes.

4. A process as claimed in claim 1, characterized in that the binder used is a novolak.

5. A process as claimed in claim 1, characterized in that the light-sensitive layer of the material comprises from 3 to 50 % by weight of 1,2-quinone-diazide compounds, based on its non-volative constituents.

**Revendications**

1. Procédé pour la production de copies en relief négatives, dans lequel on expose selon l'image un matériau photosensible qui contient un liant insoluble dans l'eau, soluble dans des solutions aqueuses alcalines, et, en tant que composé photosensible, un 1,2-quinonediazide, puis on le chauffe, après refroidissement on l'expose à nouveau sans original et on le développe ensuite au moyen d'un développateur aqueux alcalin, caractérisé en ce que le matériau contient, en tant que composé photosensible, un produit d'estérification obtenu à partir de 4-(2-phényl-prop-2-yl) phénol et d'acide 1,2-benzoquinone-2-diazide-4-sulfonique ou d'acide 1,2-naphtoquinone-2-diazide-4-sulfonique ou un ester ou un amide d'un acide 1,2-naphtoquinone-2-diazide-4-carboxylique ou d'un acide 1,2-naphtoquinone-2-diazide-4-carboxylique.

2. Procédé selon la revendication 1, caractérisé en ce que l'on chauffe à une température dans la plage de 80 à 160 °C le matériau exposé selon l'image.

3. Procédé selon la revendication 1 ou 2, caractérisé en ce que l'on chauffe le matériau pendant 30 secondes à 30 minutes.

4. Procédé selon la revendication 1, caractérisé en ce que le liant est une Novolaque.

5. Procédé selon la revendication 1, caractérisé en ce que la couche photosensible du matériau contient de 3 à 50 % en poids de composés 1,2-quinonediazide, par rapport à ses constituants non volatils.